# EUROPEAN PATENT SPECIFICATION

(11) **EP 1 557 011 B1**
(45) Date of publication and mention of the grant of the patent: **05.09.2007**
(21) Application number: 03759021.3
(22) Date of filing: 28.10.2003
(51) Int. Cl.: H04L 12/56

(54) **SYSTEM AND METHOD FOR CALCULATING CHECKSUMS OF TCP SEGMENTS/UDP DATAGRAMS IN IPV4/IPV6 PROTOCOL TRANSLATION**
SYSTEM UND VERFAHREN ZUM BERECHNEN VON PRÜFSUMMEN VON TCP-SEGMENTEN BZW. UDP-DATAGRAMEN BEI DER IPV4/IPV6-PROTOKOLLÜBERSETZUNG
SYSTEME ET PROCEDE DE CALCUL DES SOMMES D'EVALUATION DE SEGMENTS TCP/DE DATAGRAMMES UDP DANS UN PASSAGE DE PROTOCOLES IPV4/IPV6

(30) Priority: 31.10.2002 KR 2002067306
(43) Date of publication of application: 27.07.2005
(73) Proprietor: Cross Semiconductor and Technology, Pundang-gu, Sungnam-si, Kyungki-do 463-783 (KR)
(72) Inventor: LEE, Min Hyoung, Gunpo-si, Kyungki-do 435-754 (KR)
(74) Representative: Banzer, Hans-Jörg
(86) International application number: PCT/KR2003/002287
(87) International publication number: WO 2004/040862

(56) References cited:
- WO-A-99/35799
- WO-A1-00/27091
- US-A1- 2002 136 216
- TSIRTSIS BT P SRISURESH CAMPIO COMMUNICATIONS G: "Network Address Translation - Protocol Translation (NAT-PT); rfc2766.txt" IETF STANDARD, INTERNET ENGINEERING TASK FORCE, IETF, CH, February 2000 (2000-02), XP015008549 ISSN: 0000-0003
- SRISURESH JASMINE NETWORKS K EGEVANG INTEL CORPORATION P: "Traditional IP Network Address Translator (Traditional NAT); rfc3022.txt" IETF STANDARD, INTERNET ENGINEERING TASK FORCE, IETF, CH, January 2001 (2001-01), XP015008805 ISSN: 0000-0003
- AFIFI, H; TOUTAIN, L.: 'Methods for IPv4-IPv6 transition' COMPUTERS AND COMMUNICATIONS, 1999. PROCEEDINGS. IEEE INTERNATIONAL SYMPOSIUM ON 06 June 1999 - 08 June 1999, pages 478 - 484, XP010344140
- SMITH, M.; HUNT, R.;: 'Network security using NAT and NAPT' NETWORKS, 2002. ICON 2002. IEEE INTERNATIONAL CONFERENCE ON 27 August 2002 - 30 August 2002, pages 355 - 360, XP002246149

## Description

### Technical Field

The present invention relates to system and method for calculating a checksum of a TCP segment/a UDP datagram, which can significantly shorten the time taken to calculate checksum values with the least amount of calculation, in translating IPv4 packets into IPv6 packets, and vice verse, thereby enhance the performance of a packet translation processing.

### Background Art

As Internet users are exponentially increasing when entering 1990s, Internet protocol version 4 (hereinafter, referred to as "IPv4"), i.e., an address system of TCP/IP which is a representative protocol constituting Internet communications, is being exhausted in a rapid speed. To this end, IETF (Internet engineering task force) has made an effort to distribute Internet protocol version (6IPv6) of a newly developed address system that will substitute IPv4. It is, however, impossible to replace the IPv6 address based Internet that is currently being used with the IPv6 based network in a day. For this reason, many experts expect that the existing IPv4 based network will be gradually replaced with the IPv6 based network as the IPv6 based network is adopted in a newly introduced network. In line with this observation, there has been made a research and development centering on it.

The IPv6 based network initially has a shape of island in the sea called the IPv4 based network. As the area of the IPv6 based network is gradually expanded, it comes to have a shape that islands called the IPv4 based networks are located in the sea called the IPv6 based network. It is expected that IPv4 and IPv6 based networks may coexist for a long time or permanently in the future. Due to this, the most realistic problem currently is protocol translation between the IPv4 and IPv6 based networks. This is because communications between the IPv4 based network and the IPv6 based network can be smoothly carried out only when protocol translation between the IPv4 and IPv6 based networks having different packet formats is well performed.

In order to enable communications between the IPv4 based network and the IPv6 based network, there is a need for an apparatus that is present in the interface between the IPv4 network and the IPv6 network, for allowing suitable translation between the two network protocols. For this purpose, IETF, etc. are writing various these and recommendations. Further, several companies and research institutes design and implement practical products based on those these and recommendations. A representative one of them is to translate the IPv4 packet into the IPv6 packet, and vice versa.

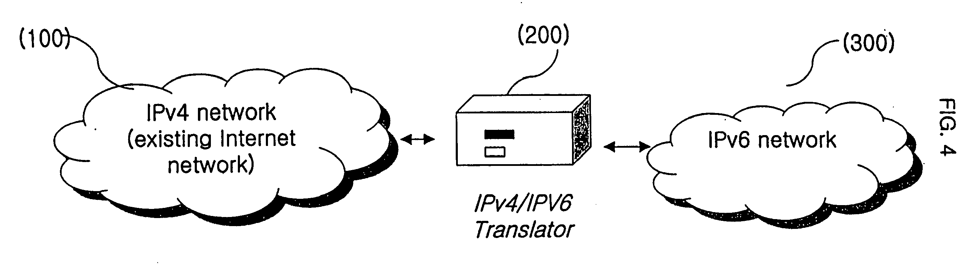

FIG. 4 shows a conceptual view for this packet translation. In other words, a reference numeral 100 designates an IPv4 based network, 200 designates an IPv4/IPv6 translator for translating IPv4 into IPv6, and vice versa, and 300 designates an IPv6 based network.

In particular, the IPv4/IPv6 translator 200 shown in FIG. 4 illustrates a conceptual structure. A method for implementing such IPv4/IPv6 translator may include translation using an IPv4/IPv6 dual stack mode, network address translation-protocol translation (NAT-PT), stateless IP/ICMP translation (SIIT), bump-in-the-stack (BIS), bump-in-the-API (BIA), and the like. This method may further include other various methods that were not proposed in the above method but are proposed by IETF, etc.

One of the most important things in the process of translating IPv6 into IPv4 is to translate an IPv6 packet header into an IPv4 packet header. Likewise, even in the process of translating IPv4 into IPv6, it is important to translate the IPv4 packet header into the IPv6 packet header.

Therefore, what IPv6 is translated into IPv4 means what the IPv6 packet header is translated into the IPv4 packet header. Similarly, what IPv4 is translated into IPv6 means what the IPv4 packet header is translated the IPv6 packet header. In other words, in case of IPv6 -> IPv4 translation, a new IPv4 packet header is generated. In case of IPv4 -> IPv6 translation, a new IPv6 packet header is generated. In this case, a checksum value of TCP/UDP or Internet control messaging protocol version 6 (ICMPv6), an upper layer protocol on which a data section of each of packets is loaded, is also newly operated. This is because the checksum value of TCP/UDP is operated for all of a pseudo header of TCP/UDP, a TCP/UDP header and a data region, wherein each IP address, a port number of a TCP / UDP region, etc. are newly specified while IPv4 -> IPv6 or IPv6 -> IPv4 translation is performed.

A method of calculating a checksum in a conventional IPv4 based network and a method of calculating a checksum in an IPv6 based network will now be described.

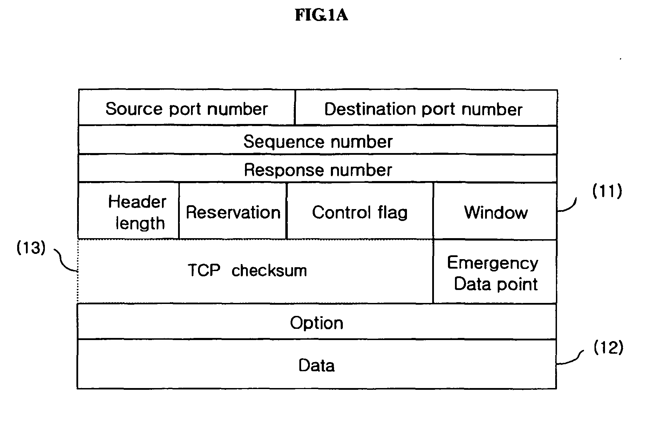

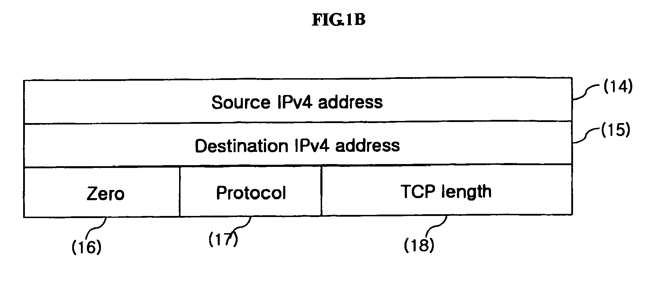

FIG. 1A shows the structure of a TCP segment. The TCP segment is largely divided into a TCP protocol header region 11 and a data region 12. A checksum region 13 of the TCP header has a length of 16 bits. A method of calculating the checksum includes dividing all information in a TCP header and a data region into words of a 16-bits length, adding them by 1's complement, and taking the results as 1's complement. When the checksum value is calculated, the checksum region itself has a value of 0. When the checksum value is calculated, however, a conceptual header called a pseudo header of a format as shown in FIG. 1B is included and calculated. The pseudo header of a TCP segment has a length of 96 bits and consists of a source IPv4 address 14, a destination IPv4 address 15, a zero 16, a protocol 17 and a TCP length 18. Such a pseudo header is calculated when the checksum value is calculated in a transmitting terminal and the checksum value is calculated in a receiving terminal. This pseudo header is not actually transmitted and functions to protect TCP segments from wrongly routing. The pseudo header is positioned immediately before the TCP header and is calculated along with the checksum value.

A method of calculating a checksum of a UDP datagram on the IPv4 based network is basically same as those in the TCP segment. In other words, the method of calculating the checksum includes dividing all information in a TCP header and a data region into words of a 16-bits length, adding them by 1's complement and taking the result as 1's complement. Of course, when the checksum value is calculated, the checksum region must have a value of 0 and the UDP pseudo header has to be also used.

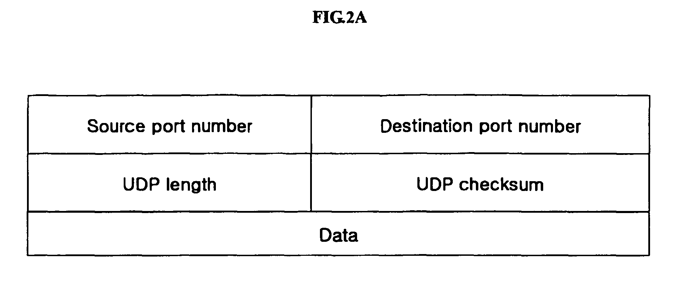

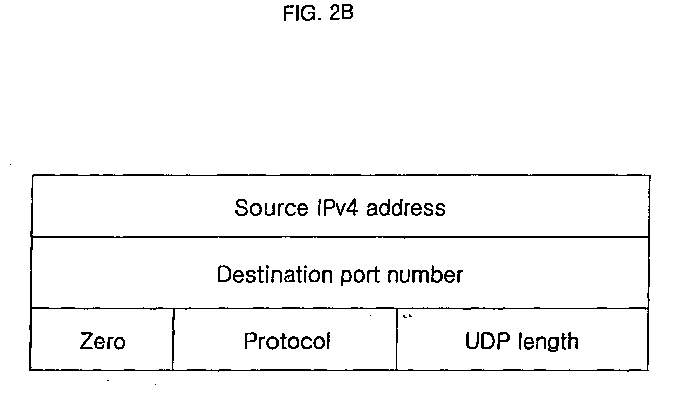

FIG. 2A shows a UDP datagram and FIG. 2B shows a UDP pseudo header format.

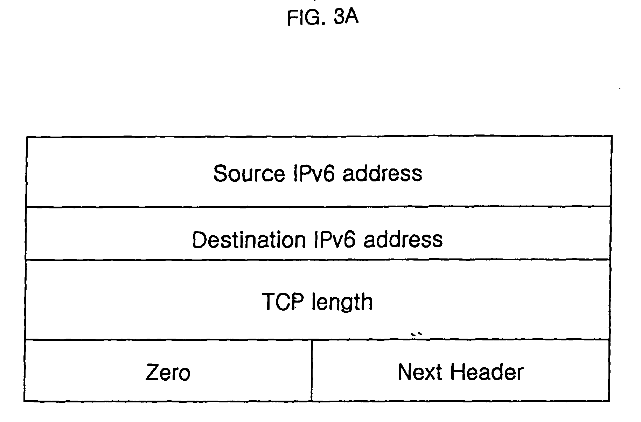

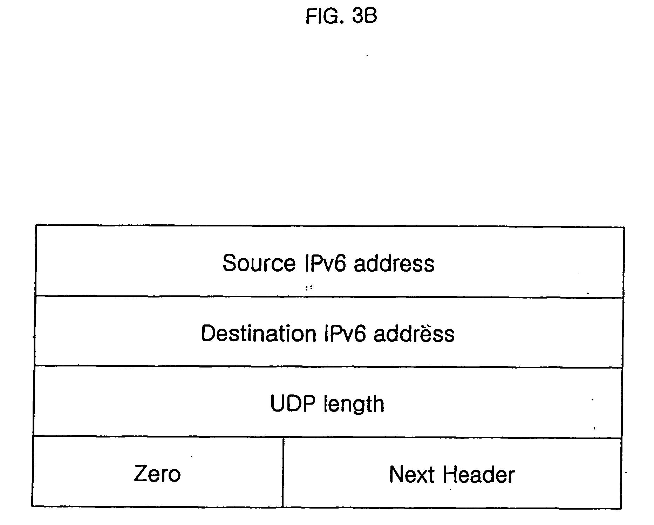

Meanwhile, the method of calculating the checksum of the TCP segment and the UDP datagram on the IPv6 based network is same as those applied in the, existing IPv4 based network. Only difference is that the pseudo header is changed for use in IPv6. FIG. 3A shows the format of the pseudo header in an IPv6 based TCP segment having a length of 320 bits, and FIG. 3B shows the format of the pseudo header in an IPv6 based UDP datagram having a length of 320 bits.

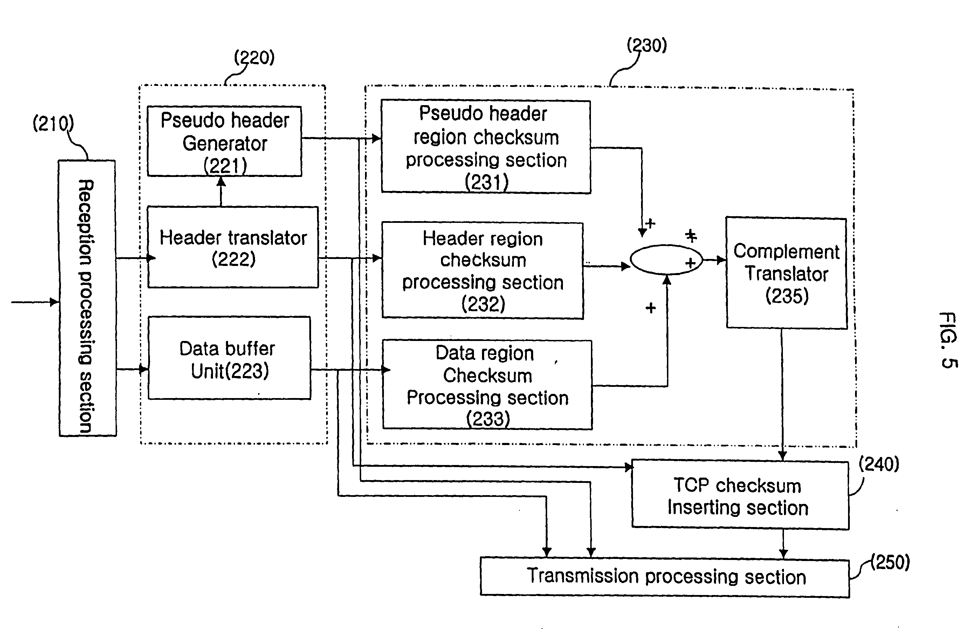

FIG. 5 is a block diagram showing an apparatus for updating a checksum within the conventional IPv4/IPv6 translator 200. The apparatus includes a reception processing section 210 for receiving a TCP segment (or a UDP datagram), a format translator 220 for translating a segment of a received conventional network based format into a segment of a new network based format, a checksum-processing unit 230 for processing a checksum every region that is translated to obtain.a checksum value of a newly updated TCP header, a checksum inserting section 240 for inserting the obtained checksum value into the checksum region of the TCP header, and a transmission processing section 250 for transmitting the translated segment to a new network.

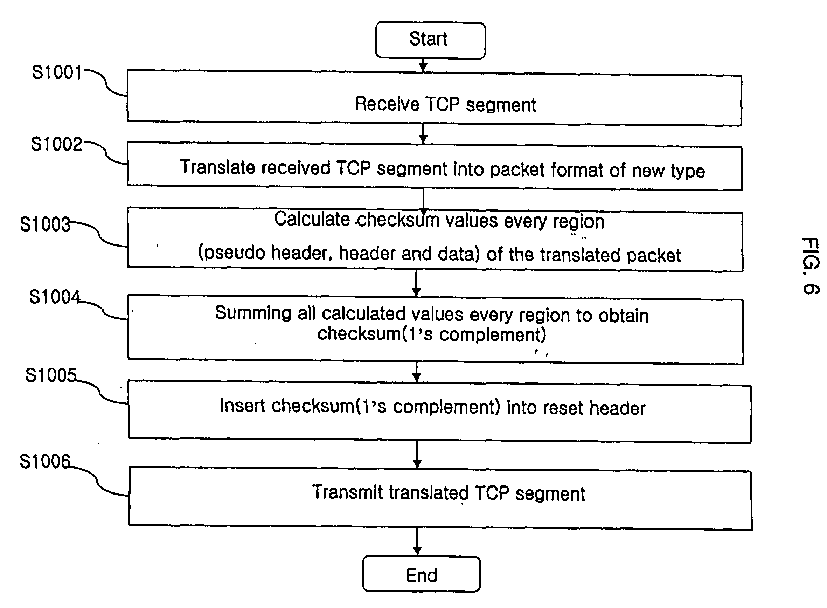

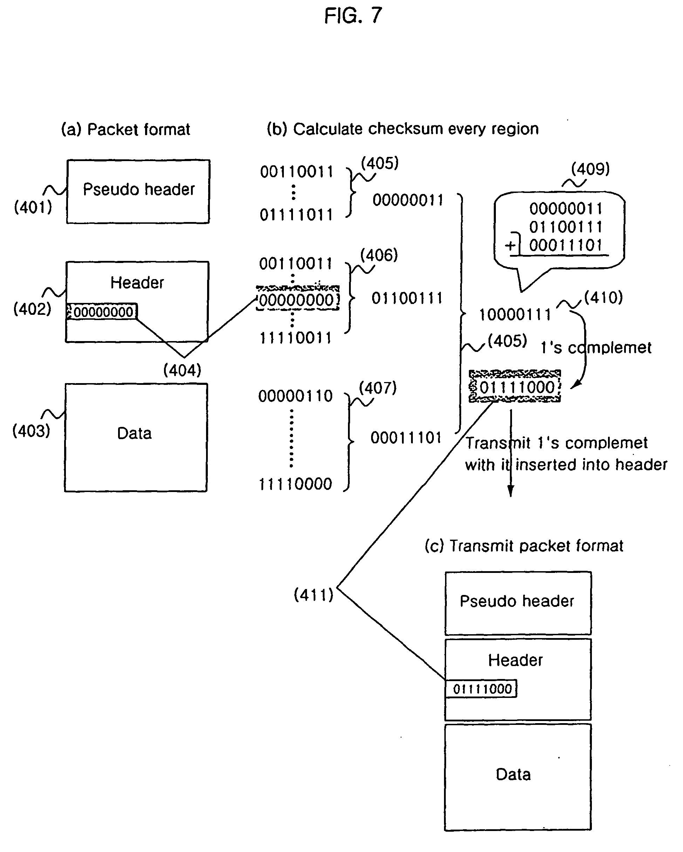

In the conventional IPv4/IPv6 translation apparatus constructed above, a method of calculating a checksum will now be described by reference to FIG. 6 and FIG. 7.

Previous network based TCP segments (or a UDP datagram) (hereinafter, referred to as "IPv4") are received through the reception processing section 210 (S1001). The received TCP segments are each translated into a format of a new type every region by the format translator 220 (S1002) ((A) in FIG. 7). In other words, the new TCP header is translated in a header translator 222. The pseudo header of the new type is newly generated in a pseudo header generator 221. Data are not translated but temporarily stored in a data buffer unit 223. Values for a region such translated are used to calculate checksum values in the checksum-processing unit 230. A Value every region is calculated in a pseudo header region checksum-processing unit 231, a header region checksum-processing unit 232 and a data region checksum-processing unit 233 (S1003). Even in this case, the checksum of the TCP header is restored again to zero and is then calculated (402 to 407 in FIG. 7(B). The values thus obtained are all added in an adder 234. The added results are translated into 1's complement in a complement translator 235 (S1004) (408 to 411 in FIG. 7(B). The values thus obtained become newly updated checksum values. This value is inserted into the checksum region of the newly translated TCP header and is transmitted to a network (hereinafter, referred to as "IPv6") other than the previous network through the transmission processing section (S1005 to S1006). Each of the IPv4 packet and the IPv6 packet consists of words of 32 bits. Each of their checksum regions has a length of 16 bits. For simplicity of the description, the checksum regions and the operations related to the checksums are indicated by 8 bits in FIG. 7.

As described so far, in the event that data are transmitted from the IPv4 network region to the IPv6 network region, and vice versa, it is required that the protocol between IPv4 and IPv6 be translated. It is not to be considered that protocol translation is finished by simply translating the IPv4 header into the IPv6 header, and vice versa. It is required that even a checksum value of a TCP segment or UDP datagram loaded on a packet be changed when the IPv4 header is translated to the IPv6 header, and vice versa. The reason may be described as follows: A pseudo header is used when the checksum value of the TCP segment or the UDP datagram is initially calculated. When translation is made at the interfaced between the IPv4 network and the IPv6 network, if an IP hierarchy header is changed, the pseudo header is also changed according to the changed IP header. It is thus necessary to calculate again the checksum value on the basis of the changed pseudo header.

In other words, when a packet is transmitted from the IPv4 network to the IPv6 network, an IPv6 based pseudo header is newly generated at their interface. In this case, values of several regions including a port number of a TCP or UDP hierarchy as well as an IP addresses are reassigned, if necessary. Checksum values are calculated using them by means of the method described above, inserted into a TCP segment header or a UDP datagram header, and are then transmitted to a destination.

In the same manner, when a packet is transmitted from the IPv6 network to the IPv4 network, an IPv4 based pseudo header is newly generated at the interface. In this case, values of several regions including a port number of a TCP or UDP hierarchy as well as an IP addresses are reassigned, if necessary. Checksum values are calculated using them by means of the method described above, inserted into a TCP segment header or a UDP datagram header, and are then transmitted to a destination.

What the checksum value inserted into the TCP segment or the UDP datagram header is calculated is what all values of the pseudo header, the TCP/UDP header and the data region are calculated. In this case, there is no significant problem since the lengths of the pseudo header and the TCP or UDP header are almost fixed. However, there are problems that the longer the length of the data region, the greater the amount of calculation. This may serve as a factor that causes a severe bottleneck condition at the interface of the IPv4 network and the IPv6 network.

Documents TSIRTSIS BT SRISURESH CAMPIO COMMUNICATIONS G: "Network Address Translation - Protocol Translation (NAT-PT); rfc2766.txt" IETF STANDARD, INTERNET ENGINEERING TASK FORCE, IETF, CH, February 2000 (2000-02), XP015008549 ISSN: 0000-0003 and SRISURESH JASMINE NETWORKS K EGEVANG INTEL CORPRATION P: "Traditional IP Network Address Translator (Traditional NAT); rfc3022.txt" IETF STANDARD, INTERNET ENGINEERING TASK FORCE, IETF, CH, January 2001 (2001-01), XP015008805 ISSN: 0000-0003 disclose a method of calculation a checksum of a TCP segment/UDP datagram in IPv4/IPv6 translation according to the preamble of independent claim 1.

### Disclosure of Invention

Accordingly, the present invention has been made in view of the above problems, and it is an object of the present invention to significantly improve a packet-processing performance by obtaining a desired checksum value even without including a value of a data region that is newly re-assigned when a checksum is calculated in a translated network.

To achieve the above object, according to an aspect of the present invention, there is provided a method of calculating a checksum of a TCP segment/UDP datagram in IPv4/IPv6 translation, comprising: a first step of adding checksum values of a pseudo header region and a header region of a received TCP segment or UDP datagram to a checksum value read out from the received TCP segment or UDP datagram; and a second step of subtracting checksum values of a newly changed pseudo header region and header region from the resulting value that is obtained in the first step.

### Brief Description of Drawings

Further objects and advantages of the invention can be more fully understood from the following detailed description taken in conjunction with the accompanying drawings in which:
FIG. 1 shows the structure illustrating a TCP segment and a pseudo header in IPv4;
FIG. 2 shows the structure illustrating a UDP datagram and a pseudo header in IPv4;
FIG. 3 shows the structure illustrating a pseudo header of a TCP segment and an UDP datagram in IPv6;
FIG. 4 is a diagram showing an IPv4/IPv6 based network and translator;
FIG. 5 is a block diagram showing a checksum calculating apparatus in IPv4/IPv6 translation according to a prior art;
FIG. 6 is a flowchart illustrating a method of calculating checksums in IPv4/IPv6 translation according to a prior art;
FIG. 7 is a continued view for explaining a method of calculating checksums in IPv4/IPv6 translation according to a prior art;
FIG. 8 is a block diagram illustrating the construction of a checksum calculating apparatus of a TCP segment/a UDP datagram in IPv4/IPv6 translation according to an embodiment of the present invention;
FIG. 9 is a flowchart illustrating a method of calculating the checksums of the TCP segment/the UDP datagram in the IPv4/IPv6 translation according to an embodiment of the present invention;
FIG. 10 is a continued view for explaining a method of calculating the checksums of the TCP segments/the UDP datagram in the IPv4/IPv6 translation according to an embodiment of the present invention;
FIG. 11 is a block diagram illustrating a checksum calculating apparatus of a TCP segment/a UDP datagram in IPv4/IPv6 translation according to another embodiment of the present invention;
FIG. 12 is a flowchart illustrating a method of calculating the checksums of the TCP segment/the UDP datagram in the IPv4/IPv6 translation according to another embodiment of the present invention; and
FIG. 13 is a continued view for explaining a method of calculating the checksums of the TCP segment/the UDP datagram in the IPv4/IPv6 translation according to another embodiment of the present invention.

### Best Mode for Carrying Out the Invention

The present invention will now be described in detail in connection with preferred embodiments with reference to the accompanying drawings.

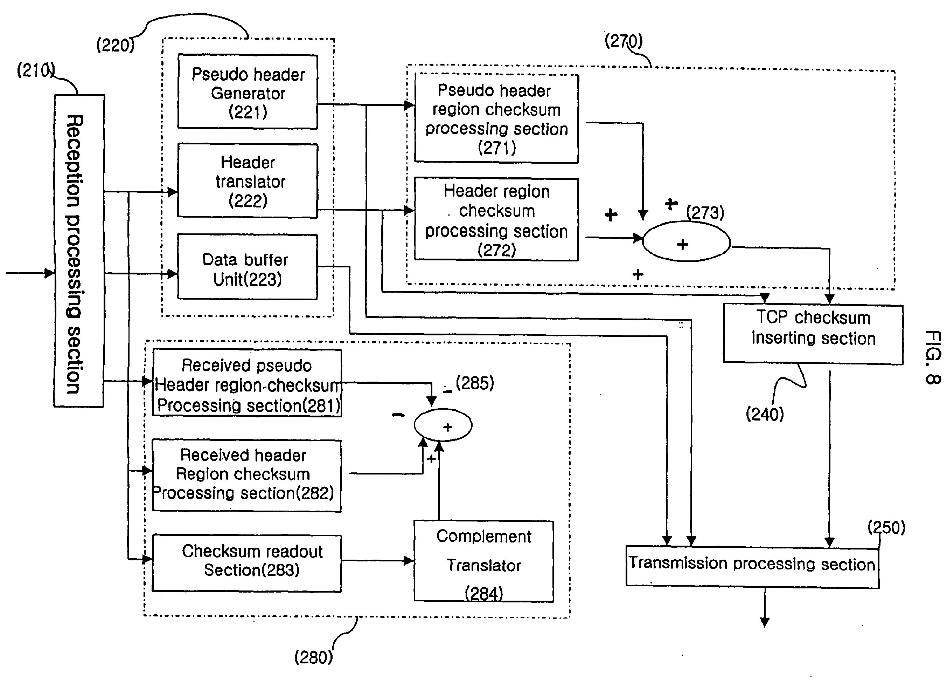

FIG. 8 is a block diagram illustrating the construction of a checksum calculating apparatus of a TCP segment/a UDP datagram in IPv4/IPv6 translation according to an embodiment of the present invention. In FIG. 8, like reference numerals are used to identify constitutional elements same as those shown in FIG. 5 according to a prior art. The difference between the construction of the present invention shown in FIG. 8 and the construction of the related art shown in FIG. 5 will now be described.

A receiving checksum-processing unit 280 of a receiving segment is added in FIG. 8, unlike FIG. 5. The receiving checksum-processing unit 280 includes a received pseudo header region checksum-processing unit 281 for operating a pseudo header value from a received TCP segment, a received header region checksum-processing unit 282 for operating a TCP header value, a checksum readout unit 283 for reading out a checksum value of the received segment, a complement translator 284, and an adder 285. Further, the conventional checksum-processing unit 230 in FIG. 5 is changed to an updated checksum-processing unit 270 for processing only a pseudo header region and a header region of a packet region that is newly translated and reset.

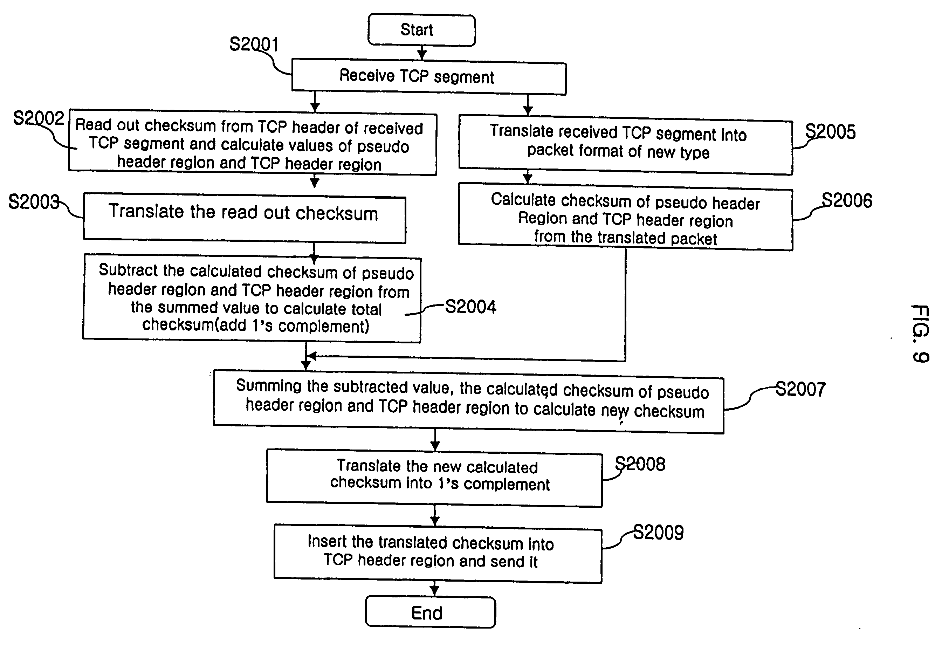

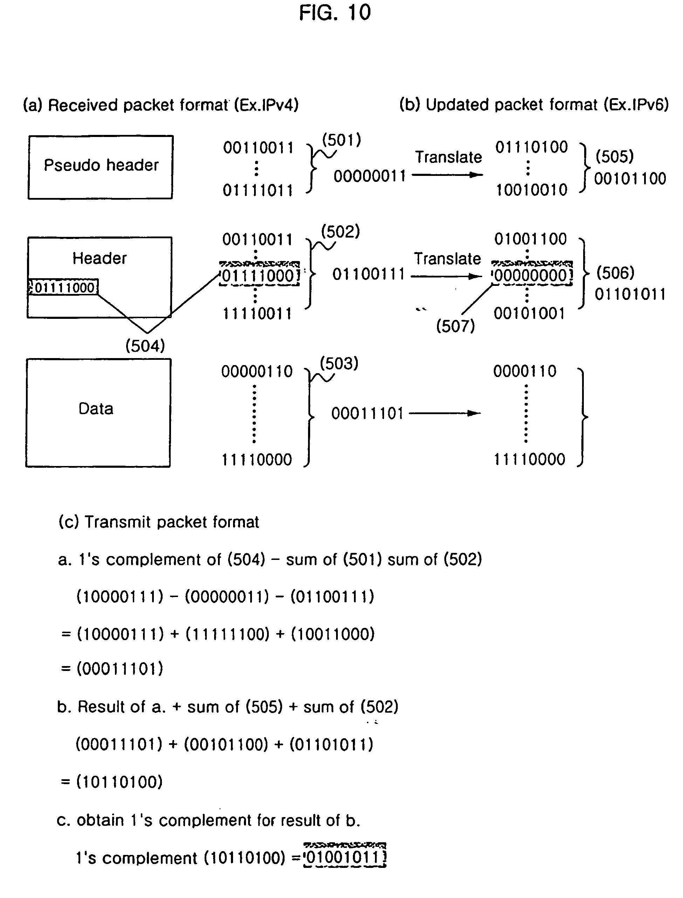

A method of processing checksums according to the present invention will now be described with reference to FIG. 9 and FIG. 10. The present invention can be applied both to IPv4 -> IPv6 translation and IPv6 -> IPv4 translation. For simplicity of the description, only IPv4 -> IPv6 translation will be described.

A TCP segment (or a UDP datagram but a TCP segment in the present context) of an IPv4 based network is first received through the reception processing section 210 (S2001). A checksum within a TCP header is read out from the received segment by the checksum readout unit 283. The values of the pseudo header and the header region are calculated in the received pseudo header region checksum-process unit 281 and the received header region checksum-process unit 282, respectively (S2002). The checksum read out in the checksum readout unit 283 is translated into 1's complement in a complement translator 284 (S2003), and is then calculated along with the calculated values of the calculated pseudo header region and the header region in the adder 285 (S2004). Meanwhile, the value of the pseudo header region and the header region of a packet that is translated into a new format through the format translator 220 is calculated in the pseudo header region checksum-processing unit 271 and the header region checksum-processing unit 272, respectively (S2005 to S2006). If the value calculated in the adder 273 and the value calculated in the receiving checksum-processing unit 280 are summed and are then translated into 1's complement in a complement translator 274, a new checksum is obtained (S2007 to S2008). The updated checksum value thus obtained is inserted into a newly translated TCP header by means of the checksum inserting section 240 and is then transmitted to the IPv6 based network through the transmission processing section 250 (S2009).

FIG. 10 is a continued view for explaining the calculation method as above. FIG. 10A shows a packet format (i.e., receiving packet format) on the IPv4 based network. In practical, each of the IPv4 packet and the IPv6 packet consists of words of 32 bits. Each of their checksum regions has a length of 16 bits. For simplicity of the description, however, only operations related to the checksum region and the checksum is shown in FIG. 10. A reference numeral 501 designates an operation for values of a received pseudo header, 502 indicates an operation for values of a TCP header and 503 indicates an operation for data. In the present invention, however, it is not necessary to indicate the data region. A reference numeral 504 designates a received checksum value. FIG. 10B shows a packet format that is newly updated into IPv6. 505 indicates a pseudo header region and 506 designates an operation for a header region. At this time, the checksum of the header is zero. FIG. 10C shows an example of a process of calculating a checksum according to the present invention depending on the flowchart of FIG. 9.

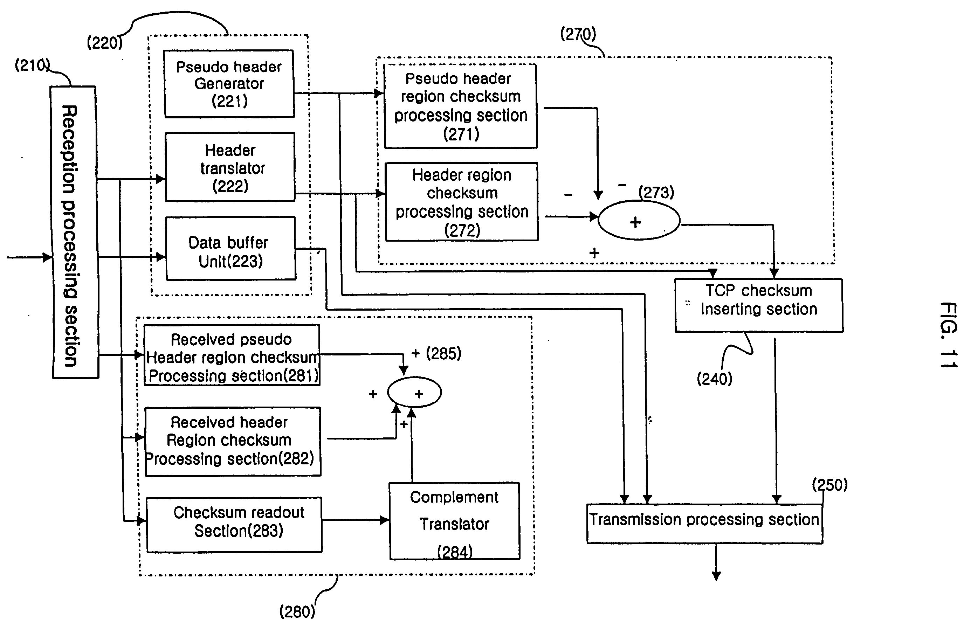

FIGs. 11 to 13 illustrate another embodiments of the present invention.

The construction shown in FIG. 11 is almost same as the construction shown in FIG. 8, except for the checksum-processing unit 280 of the receiving segment and the updated checksum-processing unit 270. In the concrete, the checksum-processing unit 280 of the receiving segment is constructed to sum the values that are processed in the received pseudo header region checksum-process unit 281, the received header region checksum-process unit 282 and the checksum readout unit 283 in the adder 285. Further, the updated checksum-processing unit 270 includes an subtracter 273 for subtracting the value processed in the pseudo header region checksum-processing unit 271 and the header region checksum-processing unit 272 from the value outputted the value outputted from the receiving segment checksum-processing unit 280.

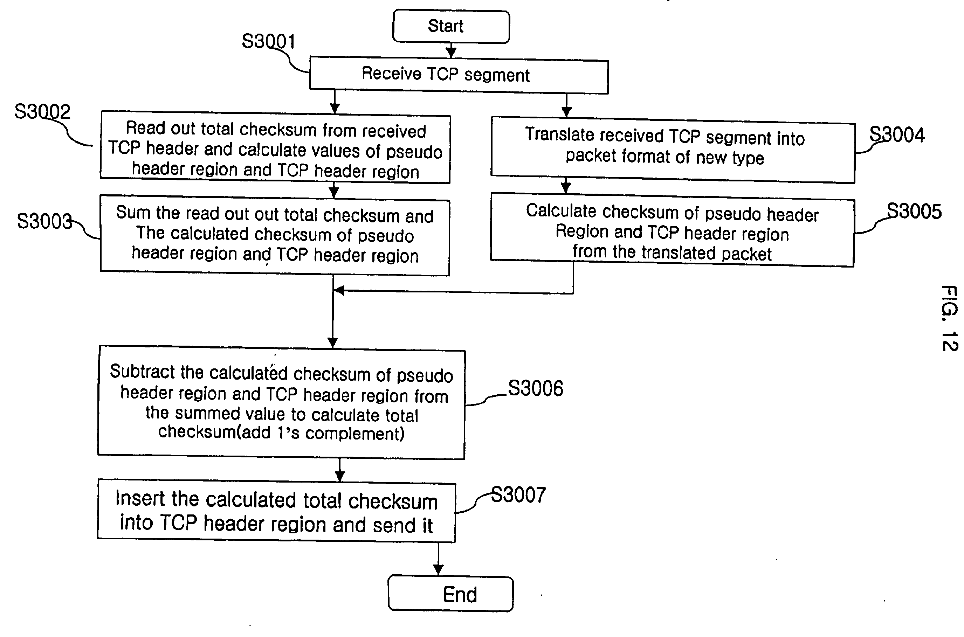

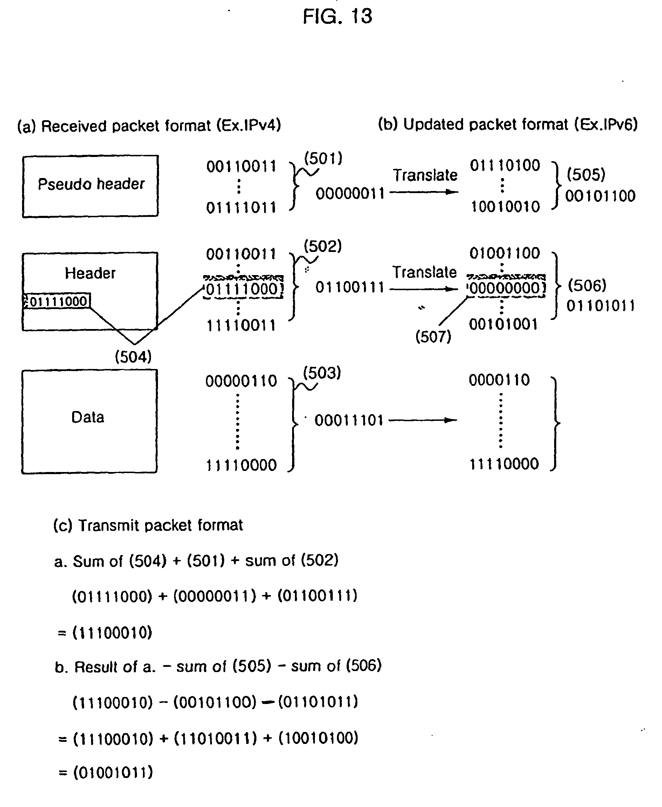

A method of calculating checksums of a TCP segment/a UDP datagram in translating IPv4/IPv6 according to another embodiment of the present invention will now be described with reference to FIG. 12 and FIG. 13.

A TCP segment (or a UDP datagram but a TCP segment in the present context) of an IPv4 based network is received through the reception processing section 210 (S3001). The checksum within a TCP header is read out from the received segment by the checksum readout unit 283. A value of the pseudo header and the header region is calculated in the received pseudo header region checksum-process unit 281 and the received header region checksum-process unit 282, respectively (S3002). The checksum read out by the checksum readout unit 283 and the value of the pseudo header region and the header region calculated by the adder 285 are operated (S3003). Meanwhile, the value of the pseudo header region and the header region of the packet that is translated into the new format through the format translator 220 is operated in the pseudo header region checksum-processing unit 271 and the header region checksum-processing unit 272, respectively (S3004 to S3005).

Afterward, if subtracting the value calculated by the subtracter 273 from the value calculated by the receiving checksum-processing unit 280, a new checksum is obtained (S3006). At this time, the subtraction method includes only taking 1's complement. The checksum of the updated checksum value thus obtained is inserted into the newly translated TCP header by the checksum inserting section 240 and is then transmitted to an IPv6 based network by the transmission processing section 250 (S3007) .

FIG. 13 is a continued view for explaining such calculation processing method. FIG. 13(a) shows a packet format (i.e., a receiving packet format) on the IPv4 based network. In practical, the length of the IPv4 packet consists of words of 16 bits and IPv6 consists of words of 32 bits. For simplicity of the description, however, they are indicated with 8 bits. A reference numeral 501 indicates an operation for values of the received pseudo header, 502 designates an operation for values of a TCP header and 503 represents an operation for data. In the present invention, however, it is not necessary to operate the data region. A reference numeral 504 indicates the received checksum value. FIG. 13(b) shows a packet format that is newly translated into IPv6. A reference numeral 505 indicates a pseudo header region and 506 designates an operation for the header region. In this case, the checksum of the header is zero. FIG. 13(c) shows an exemplary process of calculating the checksum of the present invention depending on the flowchart of FIG. 12.

### Industrial Applicability

According to the present invention described above, in translating an IPv4 packet into an IPv6 packet, or the vice versa, a desired checksum value can be obtained even without including a value of a data region that is newly assigned upon calculation of a checksum. Therefore, the present invention has advantages in that it can significantly reduce the time taken to calculate the checksum value with the least amount of calculation and enhance the performance of a packet translation processing.

While the present invention has been described with reference to the particular illustrative embodiments, it is not to be restricted by the embodiments but only by the appended claims.

## Claims

1. A method of calculating a checksum of a TCP segment/UDP datagram in IPv4/IPv6 translation, **characterized by**:
a first step (S3003) of adding checksum values of a pseudo header region and a header region of a received TCP segment or UDP datagram to a checksum value read out from the received TCP segment or UDP datagram; and
a second step (S3006) of subtracting checksum values of a newly changed pseudo header region and header region from the resulting value that is obtained in the first step.

## Patentansprüche

1. Verfahren zum Berechnen einer Prüfsumme eines TCP-Segments/UDP-Datagramms bei einer IPv4/IPv6-Umsetzung, **gekennzeichnet durch**:
einen ersten Schritt (S3003) eines Addierens von Prüfsummenwerten eines Pseudokopfbereichs und eines Kopfbereichs eines empfangenen TCP-Segments oder UDP-Datagramms zu einem Prüfsummenwert, welcher von dem empfangenen TCP-Segment oder UDP-Datagramm ausgelesen wird; und
einen zweiten Schritt (S3006) eines Subtrahierens von Prüfsummenwerten eines neu geänderten Pseudokopfbereichs und Kopfbereichs von dem sich ergebenden Wert, welcher in dem ersten Schritt erhalten wird.

## Revendications

1. Procédé pour calculer une somme d'évaluation d'un segment TCP/d'un datagram UDP dans un passage de protocole IPv4/IPv6, comprenant :
une première étape d'addition de valeurs de somme d'évaluation d'une région de pseudo-en-tête et d'une région d'en-tête d'un segment TCP ou d'un datagram UDP reçu avec une valeur de somme d'évaluation lue à partir du segment TCP ou du datagram UDP reçu ; et
une deuxième étape de soustraction de valeurs de somme d'évaluation d'une région de pseudo-en-tête et d'une région d'en-tête nouvellement changées de la valeur de résultat obtenue à la première étape.
